# EUROPÄISCHE PATENTSCHRIFT

(11) **EP 4 297 110 B1**
(45) Veröffentlichungstag und Bekanntmachung des Hinweises auf die Patenterteilung: **20.05.2026**
(21) Anmeldenummer: 22179904.2
(22) Anmeldetag: 20.06.2022
(51) Int. Cl.: H10N 60/30, H10N 60/20, H10N 60/01, H01B 7/22, H01F 41/12, H01F 6/06, H01B 12/06

(54) **SUPRALEITENDER FEHLERSTROMBEGRENZER ODER SCHALTER**
SUPERCONDUCTING FAULT CURRENT LIMITER OR SWITCH
LIMITEUR DE COURANT DE DÉFAUT SUPRACONDUCTEUR OU INTERRUPTEUR

(43) Veröffentlichungstag der Anmeldung: 27.12.2023
(73) Patentinhaber: Theva Dünnschichttechnik GmbH, 85737 Ismaning (DE)
(72) Erfinder: PRUSSEIT, Werner, 85737 Ismaning (DE)
(74) Vertreter: Bardehle Pagenberg Partnerschaft mbB Patentanwälte Rechtsanwälte

(56) Entgegenhaltungen:
- EP-A1- 2 731 113
- DE-A1- 3 811 051
- DE-B3- 102011 079 323
- JP-A- 2020 136 586
- AROOJ AKBAR ET AL: "Optical fibre sensing for fast hotspot detection in SFCLs", SUPERCONDUCTOR SCIENCE AND TECHNOLOGY, IOP PUBLISHING, TECHNO HOUSE, BRISTOL, GB, vol. 33, no. 11, 21 September 2020 (2020-09-21), pages 115003, XP020358267, ISSN: 0953-2048, [retrieved on 20200921], DOI: 10.1088/1361-6668/ABB200

## Beschreibung

### 1. Technisches Gebiet

Die Erfindung betrifft einen supraleitenden Fehlerstrombegrenzer oder Schalter, der einen armierten hochtemperatursupraleitenden Bandleiter, HTS-Bandleiter, umfasst. Der HTS-Bandleiter ist zudem mit mehreren Lagen einer Metallfaser umwickelt.

### 2. Stand der Technik

HTS-Bandleiter werden in der Technik zum Transport hoher Ströme, z.B. in Kabeln und Stromschienen, zur Erzeugung hoher Magnetfelder in der Analytik oder der Medizintechnik, zur Strahlführung in Beschleunigern oder zum Plasmaeinschluss in Fusionsreaktoren eingesetzt. Zudem kann der schnelle, dynamische Übergang vom verlustlosen supraleitenden Zustand in den normalleitenden Zustand bei Überlastung für schnelle Schalter und für Strombegrenzer verwendet werden.

In vielen dieser Einsatzbereiche erfolgt die Kühlung der HTS-Bandleiter durch Eintauchen bzw. Immersion in ein flüssiges, kryogenes Medium wie z.B. flüssigen Stickstoff (Siedepunkt bei 77 K), flüssigen Wasserstoff (Siedepunkt bei 21 K), Neon (Siedepunkt bei 27 K) oder flüssiges Helium (Siedepunkt bei 4.2 K). Moderne HTS-Bandleiter (sog. 2. Generation oder 2G) umfassen ein flexibles Metallsubstrat, das durch chemische oder physikalische Verfahren mit dem verwendeten HTS-Material beschichtet wird. Dieses entstammt gewöhnlich der sog. 123-Materialklasse mit der Zusammensetzung RBa2Cu3O7, wobei R ein Element oder eine Mischung aus Elementen der Gruppe der seltenen Erden (z.B. Nd, Gd, Eu, Dy, Ho, Hf) oder Yttrium (Y) bezeichnet. Da die HTS-Beschichtung typischerweise bei hohen Temperaturen (z.B. bei T > 650°C) erfolgt, kann die HTS-Beschichtung nicht direkt auf die Metallfolie aufgebracht werden. In Abhängigkeit vom verwendeten Herstellungsverfahren kommen unterschiedliche Zwischenschichten, sog. Pufferschichten, zum Einsatz, die zum einen als Diffusionsbarriere wirken, zum anderen eine kristallographische Orientierung vermitteln oder Parameter des Kristallgitters für die Epitaxie der HTS-Schicht anpassen. Sowohl die Abscheidung der Pufferschichten als auch der HTS-Schicht(en) kann mit unterschiedlichen Verfahren erfolgen, z.B. chemisch durch sog. metal-organic-deposition (MOD) eines amorphen Vorläufermaterials (precursors), der durch Temperaturbehandlung kalziniert und in die gewünschte Phase kristallisiert wird, durch metal-organic chemical vapor deposition (MOCVD), oder unterschiedliche physikalische Vakuumbeschichtungsverfahren (PVD).

In weiteren Fertigungsschritten werden die HTS-Bandleiter zumeist noch mit dünnen Metallschichten aus Ag oder Cu ummantelt. So werden Cu-Schichten mit 5 bis 20 µm Dicke häufig mit galvanischen Verfahren abgeschieden, vgl. JP 07335051 A oder EP 1 639 609 A2. Diese umlaufenden Metallschichten dienen dem Schutz, der elektrischen Stabilisierung und der Stromeinspeisung. Jedoch sind auch diese Schichten nicht immer zu 100% frei von Beschädigungen, Löchern oder Kanälen. Insbesondere am Rand, d.h. an der Schnittkante, ist die Haftung oft reduziert und die Schichten können leicht durch Kratzen an Führungsrollen bei der nachfolgenden Prozessierung beschädigt werden.

Insgesamt stellen die dünnen Schichten im und um den HTS-Bandleiter ein fragiles und empfindliches System dar, das bei der nachfolgenden Verarbeitung oder dem Einsatz in Spulen zur Erzeugung hoher Magnetfelder durch mechanische Kräfte leicht beschädigt werden kann. So können Zug- und Scherkräfte bis zur Delaminierung der Schichten führen oder durch starke Druckkräfte können Risse oder lokale plastische Deformationen (Druckstellen) im Schichtsystem entstehen.

Um HTS-Bandleiter gegen extern einwirkende Kräfte zu schützen und zu stabilisieren, kommen eine Reihe von Techniken zum Einsatz. Eine Konfiguration umfasst einen HTS-Bandleiter, der beidseitig mit Metallfolien laminiert und verlötet wird. Durch einen Überstand der Folien auf beiden Seiten entstehen zwei Kanäle längs des Leiters, die mit Lot gefüllt werden können und damit seitlich eine Lotbrücke bilden. Diese Anordnung ist in EP 1 203 415 B1 beschrieben. Ein ähnliches Verfahren zum beidseitigen Einlaminieren eines HTS-Bandleiters mit elektrisch isolierender Kunststofffolie ist in WO 2013/004392 A1 beschrieben. Dort wird der beidseitige Überstand der thermoplastischen Folie durch Wärmeeinwirkung verschweißt.

Weitere Konfigurationen zum Einpacken bzw. Ummanteln eines HTS-Bandleiters sind in den EP 2 940 699 A1 und EP 2 770 513 B1 beschrieben. Dort wird eine mit Lot-beschichtete Metallfolie mit doppelter Breite des HTS-Bandleiters um diesen herum gefaltet und verlötet, so dass Vorderseite und Kanten komplett bedeckt sind. Die Naht auf der Rückseite des Leiters kann dabei auch mit Lot gefüllt werden, so dass auch von dort kein Einsickern z.B. von Kühlflüssigkeiten mehr möglich ist.

Um HTS-Bandleiter ohne Löcher elektrisch zu isolieren, wurde ein Verfahren entwickelt, bei dem dieser mit einem dünnen Kunststoffband, helixartig, überlappend umwickelt wird. Dieses kann z.B. aus Polyimid (Kapton^{™}) wie in der DE 3 823 938 A1 beschrieben oder Polyester bestehen (vgl. DE 10 2004 048 439 A1). Polyimid hat einen geringen Wärmeausdehnungskoeffizient, versprödet kaum und ist deshalb für den Einsatz bei tiefkalten Temperaturen besonders geeignet. Auch klassische, thermisch- oder UV-härtbare Lacke oder Harze kommen zum Einsatz, um HTS-Bandleiter mit einem elektrisch isolierenden Überzug zu versehen. Beispielhafte Systeme sind in EP 2 801 983 A1, EP 2 731 113 B1 oder DE 10 2018 217 480 A1 beschrieben.

Alle genannten Verfahren werden zur Umhüllung von HTS-Bandleitern in der Praxis eingesetzt. Allerdings ergeben sich dabei auch praktische Schwierigkeiten. So sind Bänder nie ideal gerade, sondern weisen immer einen gewissen Säbel auf, d.h. eine Abweichung von der Geraden. Dadurch ist das akkurate Justieren und Führen von drei parallelen Bändern beim Einlaminieren problematisch, was die Fertigung langer Stücklängen schwierig macht und die Maßhaltigkeit (Breitentoleranz) beeinträchtigt. Tatsächlich lässt sich die genaue Lage des innenliegenden HTS-Bandleiters, des sog. "Insert", relativ zum Rand kaum kontrollieren. Durch seitlichen Versatz kann sich der HTS-Bandleiter ganz auf eine Seite verschieben, so dass dort kein Überstand der beiden Metallfolien und keine Lotbrücke entsteht. Ein daraus resultierendes Problem ist, dass das Sandwich an solchen Stellen aufplatzen kann.

Die Verwendung metallischer, verlöteter Bänder löst zudem nicht das Problem der elektrischen Isolierung, und bei kurzzeitiger Überlastung kann das Lot derart warm werden (> 250°C), dass die Schmelztemperatur des Lots erreicht wird und sich der Sandwich-Verbund auflöst. In diesem Fall stellt die Laminierung auch keinen mechanischen Schutz mehr dar. Dünne Lackschichten stellen hingegen keinen wirksamen mechanischen Schutz dar und auch die Benetzung der Bandkanten stellt ein Problem dar. Bei Verwendung von Fluorpolymeren oder Polyimiden zur Umwicklung oder als Lack ist dagegen die Oberflächenhaftung stark reduziert. Diese Oberflächen eignen sich daher schlecht zum Verkleben und den späteren Verguss.

Den vorstehend beschriebenen Verfahren ist gemeinsam, dass durch die Laminierung (oder das Umwickeln mit Bändern) die Dicke des HTS-Bandleiters und damit seine Steifigkeit enorm (nämlich mit der dritten Potenz der Dicke) zunimmt. Diese Leiter sind also nicht mehr so flexibel zu verarbeiten, wie der nicht laminierte HTS-Bandleiter .

Ferner treten vor allem in Spulen zur Erzeugung hoher Magnetfelder enorme mechanische Kräfte auf, die an den Oberflächen der Wicklungen angreifen. Um eine mechanisch stabile Wicklung zu erzeugen, werden solche Spulen mit Epoxidharzen, Wachsen oder anderen Polymeren vergossen und ausgehärtet. Für den Spulenbau werden an die HTS-Bandleiter deshalb zusätzliche Anforderungen gestellt. Diese betreffen die elektrische Isolation und Durchschlagfestigkeit, sowie die Imprägnierbarkeit der Wicklungszwischenräume, d.h. die HTS-Bandleiteroberfläche muss Verguss und Verklebung der einzelnen Wicklungslagen erlauben. Die aus dem Stand der Technik bekannten Leiter sind für solche und ähnliche Einsatzgebiete nur unzureichend geeignet.

DE 102 08 139 A1 beschreibt ein Verfahren zur Herstellung einer allseitigen Umhüllung aus einem elektrischen Isolationsmaterial aus Kunststoff um mindestens einen Supraleiter, bei dem ein Schmelzeschlauch aus einem geschmolzenen thermoplastischen Isolationsmaterial auf die Oberfläche des Supraleiters extrudiert wird. Zur Erzielung einer mechanischen Verstärkung wird dem dabei verwendeten thermoplastischen Isolationsmaterial ein Anteil an Fasern eines Faserwerkstoffs beigemengt.

DE 3811051 A1 offenbart ein supraleitendes Kabel umfassend ein starres Innenrohr, in dem mindestens ein supraleitender Leiterkern mit einem oxidkeramischen Hochtemperatur-Supraleitermaterial angeordnet ist, der durch ein entsprechendes Kühlmedium gekühlt wird.

DE 10 2011 079 323 B3 beschreibt eine supraleitende Spulenanordnung aus einem HTS-Leitermaterial auf einen Spulenträger. Zur mechanischen Stabilisierung der Spulenanordnung ist zwischen jeweils zwei benachbarten Spulenwindungen sowie zwischen dem Spulenträger und der diesen umgebenden Spulenwindung ein Vergussmaterial vorgesehen.

AROOJ AKBAR ET AL, "Optical fibre sensing for fast hotspot detection in SFCLs", SUPERCONDUCTOR SCIENCE AND TECHNOLOGY, IOP PUBLISHING, TECHNO HOUSE, BRISTOL, GB, vol. 33, no. 11, doi:10.1088/1361-6668/ABB200, ISSN 0953-2048, (20200921), beschreibt die Aufbringung einer Glasfaser als Messleitung auf einen HTS-Bandleiter.

JP 2020 136586 A betrifft einen supraleitenden Spulenleiter. Der supraleitende Spulenleiter umfasst bandförmige supraleitende Drähte, die aus mehreren Elementen mit unterschiedlichen thermischen Schrumpfungsverhältnissen bestehen, eine Faser, deren thermisches Schrumpfungsverhältnis bei einer Absolut-Temperatur von 293 K bis 77 K gleich oder kleiner als 0,3 % ist und die um die supraleitenden Drähte gewickelt ist, und Harze, die die Lücken zwischen jeweils benachbarten supraleitenden Drähten und der Faser sowie zwischen den anderen supraleitenden Drähten und der Faser ausfüllen.

Die der vorliegenden Erfindung zu Grunde liegende Aufgabe besteht somit darin, einige der vorstehend beschriebenen Nachteile des Standes der Technik zumindest teilweise zu verringern und insbesondere die empfindlichen HTS-Bandleiter für die weitere Verarbeitung und die Verwendung in anspruchsvollen Anwendungen mechanisch robust zu machen, vor Zerstörung zu schützen.

### 3. Zusammenfassung der Erfindung

Die vorstehend angeführte Aufgabe wird zumindest teilweise durch den Gegenstand der unabhängigen Ansprüche der vorliegenden Erfindung gelöst. Beispielhafte Ausführungsformen sind Gegenstand der abhängigen Ansprüche.

In einer Ausführungsform stellt die vorliegende Erfindung einen supraleitenden Fehlerstrombegrenzer oder Schalter bereit, aufweisend: einen hochtemperatursupraleitenden Bandleiter, HTS-Bandleiter, der eine Breite und eine Dicke aufweist; und eine Armierung, die dadurch ausgebildet ist, dass der HTS-Bandleiter mit einer ersten Lage zumindest einer Faser eines ersten Typs umwickelt ist, die einen im Wesentlichen runden Querschnitt aufweist, wobei die Faser im Wesentlichen ohne Überlappung und auf Stoß dicht aneinander liegend gewickelt ist, und der HTS-Bandleiter mit mehreren Lagen einer Metallfaser umwickelt ist.

Der Begriff Hochtemperatursupraleiter ist im Kontext der vorliegenden Erfindung technisch zu verstehen, und zwar im Sinne von einem Stück elektrischem Leiter, der hochtemperatursupraleitende Eigenschaften aufweist.

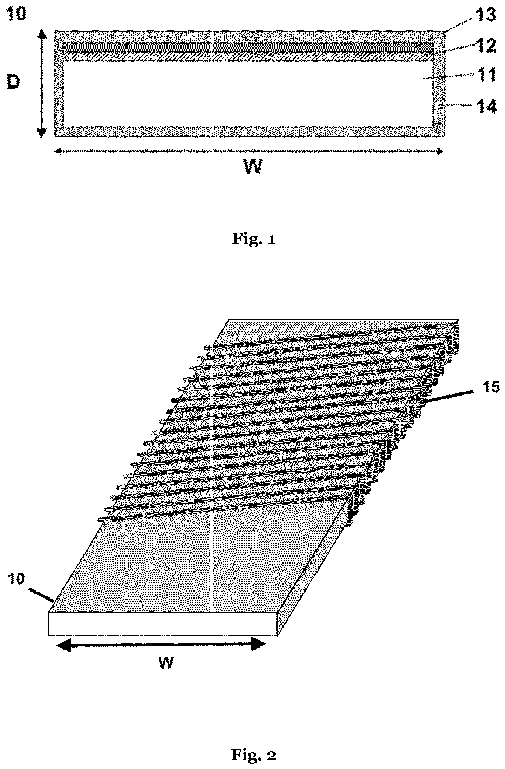

Die hierin beschriebene Erfindung (vgl. auch nachstehend die Abbildungen Fig. 1 bis Fig. 4b) ermöglicht beispielsweise ein dichtes Umwickeln des HTS-Bandleiters mit einer oder mehreren dünnen, flexiblen, aber stabilen Fasern. Diese stellt einen umlaufenden Schutz dar, der extern einwirkende Kräfte aufnimmt und verteilt, die Biegesteifigkeit in Längsrichtung nicht wesentlich beeinträchtigt und Zwischenräume aufweist, die hohe Flexibilität gewährleisten und durch Kapillarkräfte eine Imprägnierung bzw. den Verguss des HTS-Bandleiters erlauben. Insbesondere verändert eine solche Armierung die Flexibilität des HTS-Bandleiters nur geringfügig, da sich die Wicklungen der Armierung gegeneinander verschieben können. Dadurch wird auch das Eindringen von Kühlflüssigkeit oder Vergussflüssigkeit und deren Haftung erleichtert.

Die Armierung erfolgt durch das Umwickeln des HTS-Bandleiters mit einer oder mit mehreren parallelen Fasern. Mehrere Fasern können in gleichem Umlaufsinn oder gegenläufig um den HTS-Bandleiter gewickelt werden. Im letzteren Fall entstehen Überkreuzungen und die Armierung besteht aus einem Fasergeflecht. Der Begriff "Faser" wird in dieser Beschreibung als Sammelbegriff verwendet und umfasst neben einzelnen Fasern, auch Faserbündel oder zu einem Faden oder Garn gesponnene Fasern. Die Faser kann auch aus einem dünnen, metallischen Draht bestehen.

Vorzugsweise weist die Faser eine hohe plastische und / oder elastische Verformbarkeit auf und ist dünn genug, um ein enges Anliegen und einen guten Formschluss um den dünnen HTS-Bandleiter zu erreichen. Ferner sollte sie eine genügend hohe Festigkeit und Elastizität aufweisen, um unter Zugspannung um die Kanten des HTS-Bandleiters gewickelt zu werden. Typischerweise orientiert sich der Durchmesser einer einzelnen Faser an der HTS-Bandleiterdicke und liegt bevorzugt im Bereich der 0,2 bis 2,5-fachen zu umwickelnden HTS-Bandleiterdicke. Kommen gesponnene Fasern oder Garne zum Einsatz, können auch dickere Armierungen mit mehrfacher HTS-Bandleiterdicke realisiert werden. Durch mehrlagiges Aufeinanderwickeln lassen sich bei Bedarf auch sehr dicke Armierungen und Umhüllungen erzeugen, die mit anderen Methoden, z.B. Laminieren, nur schwer realisierbar sind.

Für das Faser-Material besteht eine breite Auswahl. So können für isolierende Armierungen Glas- oder Kohlefasern, aber auch Textilfasern, wie Seide, Wolle oder Baumwolle, oder Kunstfasern, wie z.B. Polyamide mit Handelsnamen wie Nylon, Perlon, Aramid, verwendet werden. Benötigt man eine Armierung mit metallischer (elektrischer oder thermischer) Leitfähigkeit, so kann dünner Metalldraht (rein oder als Lackdraht) eingesetzt werden, z.B. aus Kupfer, Kupferlegierungen, Nickel, Nickel-Chrom-Legierungen, Aluminium, Wolfram, Tantal, etc.

In einigen Ausführungsformen kann die Faser, zumindest an einigen Stellen des HTS-Bandleiters elektrisch leitend sein und bevorzugt ein metallisches Material aufweisen. Damit kann der Hochtemperatursupraleiter über die Armierung elektrisch kontaktiert werden. Auch weisen solche Materialien eine hohe thermische Leitfähigkeit auf, was die Kühlung des Hochtemperatursupraleiters, insbesondere bei lokalem Quenchen verbessern kann.

Alternativ oder zusätzlich kann die Faser, zumindest an einigen Stellen des HTS-Bandleiters elektrisch isolierend sein, und bevorzugt eine der folgenden Materialien aufweisen: eine Glasfaser, eine Kohlefaser, eine Textilfaser und eine Kunstfaser. Mit solchen elektrisch isolierten HTS-Bandleitern lassen sich insbesondere Magnetspulen für elektrische Maschinen oder MRT-Geräte fertigen.

Ferner kann die Faser so konfiguriert sein, dass kryogene Flüssigkeiten zumindest teilweise in das Innere der Faser eindringen können. Beispielsweise kann die Faser ein Geflecht aufweisen, das für kryogene Flüssigkeiten, wie etwa flüssigen Stickstoff, flüssigen Wasserstoff und flüssiges Helium zumindest teilweise durchlässig sein kann.

Sind z.B. dickere Umhüllungen angestrebt, kann der HTS-Bandleiter auch nacheinander mit mehreren Faserlagen umwickelt werden. Da zwischen den einzelnen Fasern, die einen im Wesentlichen runden Querschnitt aufweisen, Leerräume und Kanäle bleiben, können sich diese bei Deformation des armierten HTS-Bandleiters leicht gegeneinander verschieben, so dass die Steifigkeit und der minimale Krümmungsradius des HTS-Bandleiters nur geringfügig beeinflusst werden. Dies stellt einen entscheidenden Unterschied zum Stand der Technik dar, bei dem durch Laminieren ein dickerer und steiferer Verbundbandleiter entsteht. Darüber hinaus entstehen durch die Leerräume zwischen den Fasern beim Eintauchen in flüssige Medien Kapillarkräfte, die die Flüssigkeit in die Armierung saugen, wie bei einem Schwamm. Diese unterstützt also hervorragend ein nachträgliches Imprägnieren und den Verguss z.B. einer Spule.

Da die Faser als Gerüst wirkt, kann durch Kombination mit geeigneten Imprägnierflüssigkeiten, wie Polymeren, Harzen, Wachsen, Ölen oder auch Lot durch die Imprägnierung oder nach dem Aushärten eine breite Palette gewünschter Eigenschaften eingestellt werden. Dies kann z.B. die mechanische Festigkeit, die elektrische Leitfähigkeit oder Durchschlagsfestigkeit, oder die Wärmekapazität und - leitfähigkeit betreffen. Die Armierung stellt in diesem Fall ein Verbundmaterial dar, mit dem sich sehr flexibel die gewünschten Eigenschaften für die jeweilige Anwendung einstellen lassen. Sie erweitern damit das Spektrum der möglichen Bandleiterumhüllungen weit über die gängigen Metall- oder Kunststofffolien hinaus.

In einigen Ausführungsformen kann der Hochtemperatursupraleiter daher eine Schicht eines Verguss-, und /oder eines Imprägnier- und / oder eines Lotmaterials aufweisen, das zumindest teilweise in die Faser und /oder in Zwischenräume zwischen Wicklungen der Faser eingedrungen ist und eine hermetische Armierung für den HTS-Bandleiter ausbildet.

Um diese Eigenschaften der Armierung noch zu verbessern, kann die durchschnittliche Dicke der Faser in einem Bereich zwischen 0,2-mal der Dicke D und 2,5-mal der Dicke D des HTS-Bandleiters liegen und / oder in einem Bereich zwischen 30 µm bis 50 µm. Alternativ oder zusätzlich können eine oder mehrere zusätzliche Lagen der Faser oder einer weiteren Faser eines weiteren Typs über die erste Lage, bevorzugt gegenläufig bzw. über Kreuz, gewickelt sein und / oder die erste Lage der Armierung zwei oder mehr unterschiedliche Fasern unterschiedlicher Typen aufweisen. Auf diese Weise lassen sich multi-funktionale Armierungen ausbilden, die die Vorteile unterschiedlicher Fasertypen in sich vereinen.

Dicke (z.B. mehrlagige) Armierungen stellen auch einen räumlichen Puffer dar, der lokale Druckkräfte, z.B. durch Kanten oder Schmutzpartikel ausgleichen kann, so dass diese nicht in die empfindliche HTS-Bandleiteroberfläche gedrückt werden und die HTS-Schicht zerbrechen.

Die vorstehend beschriebenen Armierungen sind insbesondere nützlich für Bandleiterkonfigurationen, die einen Verbund bzw. ein Laminat zweier oder mehrerer gestapelter HTS-Bandleiter oder Folien aufweisen. Diese Konfiguration tritt insbesondere im Bereich von Patches oder Verbindungsstellen auf, wo eine elektrische Überbrückung durch einen (face-to-face) laminierten, zweiten HTS-Bandleiter erfolgt. Die Armierung verhindert das Aufspleißen dieser dickeren Stellen bei mechanischer Deformation, wie sie beispielsweise bei Umlenkung durch Rollen auftritt.

Die Armierung ermöglicht auch das Einarbeiten und die Fixierung von Messleitungen entlang des HTS-Bandleiters. Einige Ausführungsformen können daher eine Messleitung und / oder eine Kühlmittelleitung aufweisen, die durch eine der Lagen der Armierung mit dem HTS-Bandleiter verbunden ist. Insbesondere kann die Messleitung einen Lichtwellenleiter und / oder einen Temperaturfühler aufweisen die sich dadurch einfach und robust mit dem HTS-Bandleiter integrieren lassen können.

Wie vorstehend bereits angesprochen, kann in einigen Ausführungsformen der Hochtemperatursupraleiter mehrere HTS-Bandleiter aufweisen, die einen mehrlagigen Verbund bilden und / oder die an ihren Enden überlappend verbunden sind und gemeinsam mit der Faser umwickelt sind. Damit lassen sich lange und / oder mehrlagige Hochtemperatursupraleiter aus mehreren Teilleitern formen, bei denen die Verbindungsstellen durch die vorstehend beschriebene Armierung flexibel und mechanisch robust ausgestaltet werden können.

In weiteren Ausführungsformen kann die erste Lage der Armierung wenigstens eine elektrisch leitende Faser und wenigstens eine isolierende Faser aufweisen, wobei vorzugsweise die Wicklungen der elektrisch leitenden Faser gegeneinander isoliert sind. Auf diese Weise lässt sich z.B. eine Messleitung mit induktivem Verhalten oder auch eine resistive Heizleitung in die Armierung integrieren, ohne den Platzbedarf signifikant zu erhöhen.

Die vorstehend beschriebenen faserarmierten Hochtemperatursupraleiter eignen sich insbesondere für supraleitende Magnetspulen. Somit betrifft ein weiter Aspekt außerhalb der vorliegenden Erfindung eine supraleitende Spule zur Erzeugung eines Magnetfeldes aufweisend: eine oder mehrere Spulenwicklungen eines Hochtemperatursupraleiters wie vorstehend (und in Abschnitt 5. unten) beschrieben, wobei die Spulenwicklungen mit einem Vergussmaterial, bevorzugt einem Epoxidharz, verbunden sind.

Die vorliegende Erfindung betrifft einen supraleitenden Fehlerstrombegrenzer oder Schalter, aufweisend: einen Hochtemperatursupraleiter wie vorstehend (und in Abschnitt 5. unten) beschrieben, wobei der armierte HTS-Bandleiter zudem mit mehreren Lagen einer Metallfaser, bevorzugt einer Kupfer- oder Refraktärmetallfaser umwickelt ist.

Ein solcher Hochtemperatursupraleiter für einen supraleitenden Fehlerstrombegrenzer oder Schalter wie vorstehend beschrieben lässt sich beispielsweise mit dem in dem Verfahrensanspruch 6 spezifizierten Verfahren herstellen.

Ferner kann ein solches Verfahren umfassen: Erzeugen einer hermetischen Armierung durch Verlöten oder Vergießen der Armierung mit einem Lotmaterial und / oder einem Vergussmaterial.

Wird die Faser mit einer gewissen Zugspannung und elastischen Verformung auf den HTS-Bandleiter gewickelt, werden Zug- und Scherkräfte, die von außen auf den armierten HTS-Bandleiter einwirken, zum Großteil in die Fasern der Armierung abgeleitet. Die Kraftwirkung auf die Grenzflächen zum HTS-Bandleiter und zwischen seinen Schichten wird dadurch stark reduziert. Das Risiko einer Delamination, also einer flächigen Ablösung von Schichten, wird dadurch verringert. Wird die Faserwicklung nicht mit der HTS-Bandleiteroberfläche verklebt (Verguss), so nimmt die Faserarmierung sämtliche Kräfte auf, da an der Grenzfläche kein Kraftschluss besteht.

Die hier beschriebene Erfindung führt also zu armierten Hochtemperatursupraleitern mit stark verbesserten mechanischen, elektrischen und thermischen Eigenschaften, die sich in unterschiedlichen Abmessungen und Formen einfach und verlässlich fertigen lassen. Unterschiedliche Kombinationen von Fasertypen und Wicklungen ermöglichen es, die Eigenschaften der Armierung an supraleitende Fehlerstrombegrenzer oder Schalter anzupassen und zu optimieren. Die vorliegende Erfindung leistet also einen wichtigen Beitrag dazu, HTS-Bandleitertechnologie praxistauglich zu machen.

### 4. Beschreibung der Figuren

Gewisse Aspekte der vorliegenden Erfindung werden im Folgenden mit Bezugnahme auf die angefügten Figuren beschrieben. Diese Figuren zeigen:
Fig. 1: einen schematischen HTS-Bandleiteraufbau im Querschnitt vor dem Umwickeln mit einer Faser;
Fig. 2: Aufsicht auf einen schematischen HTS-Bandleiteraufbau mit einlagiger Umwicklung mit einer Faser gemäß einer Ausführungsform der vorliegenden Erfindung;
Fig. 3a: eine Darstellung eines HTS-Bandleiteraufbaus im Längsschnitt durch den HTS-Bandleiter mit einlagiger Armierung / Umwicklung gemäß einer Ausführungsform der vorliegenden Erfindung;
Fig. 3b: eine Darstellung eines HTS-Bandleiteraufbaus im Längsschnitt durch den HTS-Bandleiter mit doppellagiger Armierung gemäß einer Ausführungsform der vorliegenden Erfindung;
Fig. 3c: eine Darstellung zweier verlöteter HTS-Bandleiter mit einlagiger Armierung gemäß einer Ausführungsform der vorliegenden Erfindung;
Fig. 4a: einen Querschnitt durch einen HTS-Bandleiterverbund mit seitlich verlaufender, integrierter Messleitung (z.B. Glasfaser);
Fig. 4b: einen Querschnitt durch einen HTS-Bandleiterverbund mit zentral verlaufender, integrierter Messleitung (z.B. Glasfaser); und
Fig. 5: ein Ablaufdiagramm der Verfahrensschritte zur Herstellung eines armierten HTS-Bandleiters.

### 5. Detaillierte Beschreibung einiger Ausführungsbeispiele

Im Folgenden werden einige beispielhafte Merkmalskombinationen mit Bezugnahme auf einige beispielhafte Ausführungsformen der vorliegenden Erfindung beschrieben. Naturgemäß müssen dabei nicht alle Merkmale der beschriebenen Ausführungsformen vorhanden sein, um die vorliegende Erfindung zu realisieren. Ferner können Ausführungsformen durch Kombinieren gewisser Merkmale einer Ausführungsform mit einem oder mehreren Merkmalen einer anderen Ausführungsform modifiziert werden - falls dies technisch kompatibel und sinnvoll ist - ohne von der Offenbarung und dem Schutzumfang der vorliegenden Erfindung abzuweichen, der alleine durch die Patentansprüche definiert ist.

Fig. 1 zeigt den Aufbau eines HTS-Bandleiters 10 basierend auf einem dünnen Metallsubstrat 11, bevorzugt einer NiCr-Legierung wie Hastelloy C276, Legierungen aus Ni mit W oder Mo, oder einem hinreichend legierten, rostfreien Edelstahl. Die Substratdicke liegt bevorzugt im Bereich von 30 - 150 µm, besonders bevorzugt zwischen 40 und 100 µm. Zumindest eine Hauptfläche des Metallsubstrats ist mit einer oder mehreren Pufferschichten 12, z.B. MgO, CeO₂, Y₂O₃, LaMnO₃, LaZrO₃, beschichtet, auf denen die HTS-Funktionsschicht 13 abgeschieden ist. Diese besteht im Wesentlichen aus einer Verbindung der Gruppe RBa₂Cu₃O₇, wobei R ein Element oder eine Mischung aus Elementen der Gruppe der Seltenen Erden (häufig Nd, Gd, Eu, Dy, Ho, Hf) oder Yttrium (Y) bezeichnet. Diesem können auch andere Metalloxide als Verunreinigungen wie beispielsweise BaMO₃, wobei M für Elemente wie Zr, Hf, Ce, Sn, etc. steht, beigefügt sein, um die Magnetfeldfestigkeit zu erhöhen. Abschließend wird der HTS-Bandleiter typischerweise mit einer dünnen Schicht aus Ag umhüllt. Diese kann noch durch eine ebenfalls umhüllende Cu-Schicht verstärkt werden. Die in Fig. 1 dargestellte, umhüllende Metallschicht 14 bzw. Doppelschicht wirkt einerseits als Kontaktschicht zur Stromeinspeisung, vermitteln Haftung auf den Substratkanten und der Rückseite, und ermöglichen das Löten. Die umhüllende Ag und/oder Cu-Schicht weist typischerweise eine Gesamtdicke von mindesten 2 µm, bevorzugt zwischen 2 bis 10 µm auf. Der HTS-Bandleiter kann zur elektrischen Stabilisierung zusätzlich auch mit einer Metallfolie laminiert oder umhüllt sein. Deren Dicke liegt bevorzugt zwischen 20 bis 150 µm.

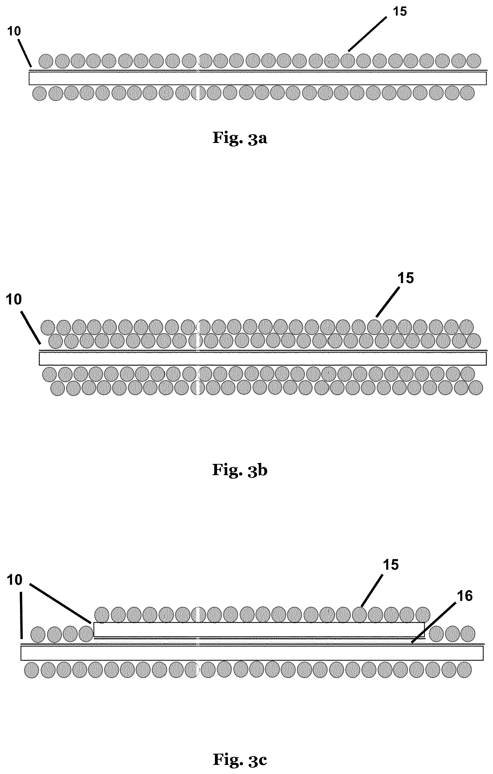

Fig. 2 zeigt einen faser-armierten HTS-Bandleiter 10 gemäß einer Ausführungsform der vorliegenden Erfindung in Aufsicht. Fig. 3a zeigt den armierten Hochtemperatursupraleiter im Schnitt entlang der zentralen Längsachse. Der Hochtemperatursupraleiter weist einen HTS-Bandleiter 10 auf, der mit einer oder mehreren Lagen Faser 15 umwickelt ist. Die Faser ist dicht an dicht gewickelt, wie in Fig. 3a dargestellt. Dies kann dadurch erreicht werden, dass beim einfachen Umwickeln Vorschub des HTS-Bandleiters und Wickelfrequenz so aufeinander abgestimmt werden, dass die Faser pro Umlauf um einen Faserdurchmesser versetzt wird.

Für das Material der Armierung bzw. der Faserwicklungen kommt eine breite Auswahl an Fasern, textilen Garnen oder dünnen Metalldrähten in Frage. Die Zugspannung beim Umwickeln liegt bevorzugt im Bereich von 50 - 250 MPa. Sie richtet sich im Einzelfall zum einen nach Material und Stärke der Faser, aber auch nach der Dicke D und Breite W des HTS-Bandleiters 10. Material und geometrischer Querschnitt des HTS-Bandleiters geben seine Biegesteifigkeit vor. Damit der armierte HTS-Bandleiter möglichst plan bleibt und die Armierung auf beiden Hauptflächen gut anliegt, sollte die Zugspannung niedrig genug gewählt werden, so dass keine zusätzliche Wölbung quer zum Leiter entsteht. Zugfestigkeit der Faser und Biegesteifigkeit des HTS-Bandleiters begrenzen also die Zugspannung beim Umwickeln von oben und von unten. Statt einer Faser können auch zwei oder mehrere Fasern parallel verwickelt werden. Dabei können parallele Fasern unterschiedliche Materialien aufweisen.

Der Vorgang des Umwickelns kann auch mehrfach hintereinander wiederholt werden, um eine bestimmte Zieldicke der Armierung einzustellen. Diese Anordnung ist exemplarisch gezeigt in Fig. 3b. Dort ist dargestellt, wie eine zweite Faserlage gleichsinnig auf den HTS-Bandleiter aufgewickelt wurde. Anders als bei einer Laminierung mit z.B. Folien, die die Biegesteifigkeit und damit die Verarbeitbarkeit des Verbundes stark beeinträchtigt, können durch das mehrfache Umwickeln praktisch beliebig dicke Ummantelungen hergestellt werden, ohne dass die Flexibilität resultierenden Hochtemperatursupraleiters und die weitere Verarbeitung wesentlich beeinträchtigt werden. Dadurch lässt sich z.B. die Wärmekapazität des Verbundbandleiters für einige Anwendungen gezielt erhöhen.

Eine besondere Konfiguration entsteht, wenn mehrere Fasern gegenläufig um den HTS-Bandleiter gewickelt werden. Durch die Überkreuzungen entsteht dabei ein Geflecht aus Fasern, das den HTS-Bandleiter umhüllt. Beide Formen der Umwicklung können zur Armierung des HTS-Bandleiters eingesetzt werden.

Eine weitere Konfiguration betrifft gestapelte und an ihrer Oberfläche verbundene HTS-Bandleiter. Eine solche Konfiguration tritt beispielsweise an Verbindungsstellen zwischen HTS-(Teil)-Bandleitern auf. Sehr lange HTS-Bandleiter mit hunderten oder gar über tausend Meter Länge werden bevorzugt durch Verbindung kürzerer Teileiter hergestellt. Idealerweise sind die Verbindungsstellen für den Endanwender praktisch unsichtbar und verhalten sich auch mechanisch wie der einfache HTS-Bandleiter. Verbindungsverfahren werden beispielsweise beschrieben in US 7,071,148 oder EP 2 835 838 A1. Letztere beschreibt auch die Reparatur (Patch) einer Defektstelle ähnlich wie EP 2 689 477 A1.

Bei der Verbindung werden die HTS-Bandleiter zunächst am Substrat mechanisch verbunden, z.B. verschweißt. Um den Stromfluss über die Stoßstelle oder über eine lokale Defektstelle zu gewährleisten, wird auf die HTS-Seite der HTS-Bandleiteroberfläche ein zweiter HTS-Bandleiter 10 mit zugewandter HTS-Seite (face-to-face) als sog. Patch 16 aufgelötet. Diese Situation ist im Längsschnitt in Fig. 3c dargestellt. Diese Überbrückung ist im Allgemeinen deutlich dicker als der einzelne HTS-Bandleiter. In der EP 2 835 838 A1 ist daher beschrieben, wie man vom Patch das Substrat selektiv ablösen kann, um diese Überbrückung möglichst dünn zu halten. In jedem Fall stellt die Verbindungs- oder Reparaturstelle jedoch einen empfindlichen Bereich dar, in dem sich auch die mechanischen Eigenschaften deutlich von denen des normalen HTS-Bandleiters unterscheiden. So steigt die Steifigkeit mit der dritten Potenz der Banddicke und beim Transport über Rollen neigen solche Stellen aufgrund der abrupten Änderung der Biegesteifigkeit zum Abknicken oder Aufspleißen und Delaminieren. Die Armierung solcher Patches oder Verbindungstellen gemäß einiger Ausführungsformen der vorliegenden Erfindung ist in Fig. 3c dargestellt. Sie hält den Verbund auch bei starker Verbiegung zusammen. So stellen Verbindungen keine mechanischen Problemstellen mehr dar und erfordern bei der weiteren Handhabung keine besondere Sorgfalt, was die Verarbeitung des Leiters sehr erleichtert.

Im Allgemeinen ist die hier beschriebene, faserbasierte Armierung ein geeignetes Mittel, um unterschiedliche Typen von HTS-Bandleiterstapeln als Verbund mechanisch zusammenzuhalten und zu schützen, unabhängig davon, ob diese Stapelung nur lokal oder auf der ganzen Länge vorliegt. Im Folgenden sollen einige konkrete Ausführungsformen und Anwendungsbeispiele beschrieben werden, um das breite Einsatzspektrum der hier beschriebenen Faserarmierung zu demonstrieren.

### Beispiel 1:

Ein HTS-Bandleiter mit umlaufender dünner Kupferschicht und einer Dicke von 70 bis 80 µm wird einlagig umwickelt mit einer stabilen, isolierenden Faser oder einem Faserbündel, z.B. einer Glas-, Kohle- oder Aramidfaser, oder einem Metalldraht aus Kupfer oder Aluminium. Die Faserstärke bzw. Dicke der Armierung beträgt ca. 30 bis 50 µm und bewirkt damit einen sehr effektiven Kantenschutz bei der weiteren Verarbeitung. Auch Kräfte, z.B. in einer Spule, können im Verbund über die Armierung an den HTS-Bandleiterkanten abgeführt werden.

### Beispiel 2:

Der armierte HTS-Bandleiter aus Beispiel 1 kann anschließend, bevorzugt bei einem Unterdruck < 400 mbar (4·10⁴ Pa), besonders bevorzugt im Bereich von 100 bis 200 mbar (d.h. zwischen 1·10⁴ Pa bis 2·10⁴ Pa), mit Epoxidharz oder Polyurethan imprägniert und bei einer geeigneten Temperatur (z.B. 150°C) ausgehärtet werden. Bei einer metallischen Armierung kann auch ein Lot mit einem Schmelzpunkt unter 250°C, z.B. mit Hilfe eines Lotbades oder einer Lötwelle aufgetragen werden. Dieses härtet beim Abkühlen aus und füllt die Zwischenräume der Armierung. In beiden Fällen entsteht eine hermetisch dichte Versiegelung, die bei Eintauchen des HTS-Bandleiters in kyrogene Flüssigkeiten wie flüssigen Stickstoff, Wasserstoff oder Helium das Eindringen der Flüssigkeiten in Hohlräume und das Aufblähen bei Erwärmung über den Siedepunkt (sog. *Ballooning*) verhindert.

### Beispiel 3

Ein HTS-Bandleiter kann z.B. mit einer oder mehreren Lagen einer Textilfaser, z.B. Baumwolle, Seide, Polyamid umwickelt sein. Die Dicke der Armierung beträgt beispielsweise 50 µm. Der armierte HTS-Bandleiter wird auf einen Former (z.B. Kabel) oder zu einer Spule gewickelt, und zur Kühlung von flüssigem Stickstoff oder flüssigem Wasserstoff, etc. umspült. Die Kühlflüssigkeit kann dadurch im Wesentlichen vollständig in die Armierung eindringen, wirkt als Dielektrikum und bewirkt eine elektrische Isolierung des HTS-Bandleiters mit einer Durchschlagsfestigkeit von mehr als 20 kV/mm.

### Beispiel 4

Ein mehrere hundert Meter langer HTS-Bandleiter weist eine oder mehrere Verbindungsstellen oder Patches auf, an denen ein zweiter HTS-Bandleiter face-to-face auf der HTS-Seite flächig aufgelötet und damit elektrisch verbunden ist. Diese Verbindungsstellen werden mit einer Faser mit hoher Zugfestigkeit, wie z.B. Glas-, Kohle- oder Aramid-Faser, umwickelt und damit effektiv mechanisch zusammengehalten. Beim Transport des langen HTS-Bandleiters über Rollen besteht dadurch keine Gefahr mehr, dass diese Verbindungsstellen aufspleißen und der HTS-Bandleiter kann problemlos weiterverarbeitet werden ohne dass besondere Vorsichtsmaßnahmen an den Verbindungstellen erforderlich wären.

### Beispiel 5

Ein mit einer Textil- oder Kunstfaser armierter HTS-Bandleiter wird zu einer Magnetspule aufgewickelt. Diese Spule wird bei Unterdruck < 400 mbar (4·10⁴ Pa) mit einem Epoxidharz, Polyurethan oder einem Wachs vergossen. Die Harze werden bei Temperaturen oberhalb 100°C vernetzt und ausgehärtet, das Wachs erstarrt beim Abkühlen. Dadurch entsteht ein mechanisch stabiler Verbund mit innigem Kontakt und sehr gutem Kraftschluss zwischen HTS-Bandleiter und der Vergussmasse. Zudem können dadurch glatte Spulenoberflächen realisiert werden über die eine gute Ankopplung an gekühlte Flächen, z.B. aus Kupfer, und damit eine effektive Wärmeabfuhr möglich ist. Die Vergussmasse bewirkt auch eine elektrische Isolierung der HTS-Wicklungen der Spule untereinander und weist eine Durchschlagsfestigkeit von mehr als 20 kV/mm auf.

### Beispiel 6

Ein HTS-Bandleiter wird mit einem Metalldraht aus Kupfer, NiCr, und / oder einem Refraktärmetall wie W, Mo, Ta umwickelt. Durch elektrische Strompulse durch diese Armierung lässt sich der HTS-Bandleiter aufheizen und der Übergang vom supraleitenden in den normalleitenden Zustand auslösen. Über die effektive Länge der Strombahn und die Kontaktwiderstände zwischen den Wicklungen kann der Heizwiderstand eingestellt werden. Der Kontaktwiderstand lässt sich zudem über eine Imprägnierung / Verguss mit einem leitfähigen Füllmaterial, z.B. Lot, Silbertinte, oder metallgefüllte Polymere einstellen. Mit einem solchen HTS-Bandleiter lassen sich beispielsweise hochtemperatursupraleitende Schalter und getriggerte Strombegrenzer realisieren.

### Beispiel 7

In einem supraleitenden Fehlerstrombegrenzer (engl. *superconducting fault current limiter,* SFCL) oder Schalter wird ein HTS-Bandleiter in Sekundenbruchteilen durch starke Stromüberlastung vom supraleitenden in den normalleitenden Zustand getrieben. Um den kurzzeitigen, extrem hohen Energieeintrag unbeschadet zu überstehen, werden HTS-Bandleiter mit möglichst hoher Wärmekapazität und hohem Längswiderstand benötigt. Durch mehrlagiges Umwickeln mit dünnem Metalldraht, wie z.B. Kupfer oder Refraktärmetallen, lässt sich eine dicke metallische Umhüllung mit hoher Wärmekapazität ausbilden. An der Oberfläche des HTS-Bandleiters 10 kann durch eine Lotschicht zudem eine gute Wärmeankopplung an die Armierung erreicht werden. Der Längswiderstand der Armierung lässt sich wie in Bsp. 6 kontrolliert einstellen.

### Beispiel 8

Ein HTS-Bandleiter wird parallel mit einem Metalldraht aus Kupfer, NiCr, oder einem Refraktärmetall wie W, Mo, Ta und einem oder mehreren elektrisch isolierenden Fasern umwickelt. In der Armierung sind die Wicklungen des Metalldrahts also durch elektrisch isolierende Bereiche getrennt, bzw. der Metalldraht ist in eine isolierende Matrix eingebettet. Dieser Draht kann entweder als Signal- oder Messleitung genutzt werden oder ähnlich wie in Bsp. 6 mit Strompulsen gespeist werden. Der effektive Heizwiderstand kann durch diese Konfiguration in noch weiteren Grenzen variiert werden, als durch dicht liegende Metalldrähte.

### Beispiel 9

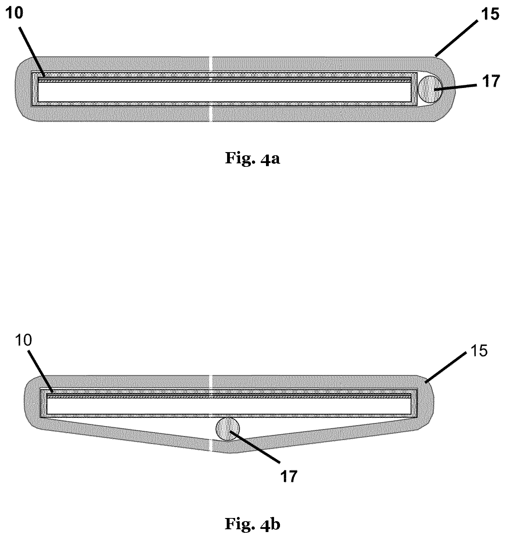

Eine Messleitung 17 (z.B. ein Lichtwellenleiter mit Bragg-Gittern) begleitet den HTS-Bandleiter in axialer Richtung und wird durch die erfindungsgemäße Armierung mechanisch mit dem HTS-Bandleiter verbunden (vgl. Fig.4a und Fig. 4b). Die Messleitung erlaubt die Überwachung des HTS-Bandleiters im Betrieb, insbesondere wenn es lokal zur Erwärmung oder einem Quench, d.h. dem Übergang in den normalleitenden Zustand, kommt. Die Messleitung kann am Rand des HTS-Bandleiters (Fig. 4a) oder auf und entlang einer der Hauptflächen des HTS-Bandleiters (Fig. 4b) angeordnet und durch die Armierung fixiert werden.

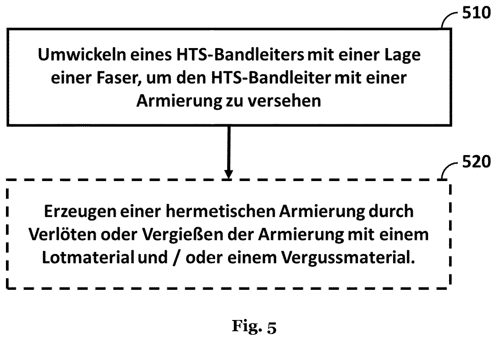

Fig. 5 zeigt ein Ablaufdiagram eines Herstellungsverfahrens gemäß einer Ausführungsform der vorliegenden Erfindung. In einem ersten Schritt 510 wird ein HTS-Bandleiter oder mehrere untereinander verbundene (z.B. face-to-face) HTS-Bandleiter - wie vorstehend beschrieben - mit mindestens einer Lage Faser umwickelt, die im Wesentlichen einen runden Querschnitt hat, um eine Armierung auszubilden wie vorstehend im Detail beschrieben ist. Anschließend kann in einigen Ausführungsformen eine hermetische Armierung durch Verlöten oder Vergießen der Armierung mit einem Lotmaterial und / oder einem Vergussmaterial erzeugt werden (Schritt 520).
Weitere Ausführungsformen eines solchen Herstellungsverfahrens und geeigneter Fasern und Vergussmaterialen sind vorstehend, insbesondere in Abschnitt 3 ausführlich beschrieben.

### Bezugszeichenliste:

- 10: HTS-Bandleiter (*insert*)
- 11: Metallsubstrat
- 12: Pufferschicht(en)
- 13: HTS-Schicht
- 14: umhüllende Metallschicht aus Ag, Ag und Cu oder Ag, Cu und Lot
- 15: Faser-Armierung / Umwicklung
- 16: Lotschicht zwischen HTS-Bandleitern
- 17: Messleitung (z.B. Glasfaser)
- W: HTS-Bandleiterbreite
- D: HTS-Bandleiterdicke

## Patentansprüche

1. Supraleitender Fehlerstrombegrenzer oder Schalter aufweisend:
einen hochtemperatursupraleitenden Bandleiter (10), HTS-Bandleiter, der eine Breite (W) und eine Dicke (D) aufweist; und
eine Armierung, die dadurch ausgebildet ist, dass der HTS-Bandleiter (10) mit einer ersten Lage zumindest einer Faser (15) eines ersten Typs umwickelt ist, die einen im Wesentlichen runden Querschnitt aufweist, wobei die Faser (15) im Wesentlichen ohne Überlappung und auf Stoß dicht aneinander liegend gewickelt ist, wobei der HTS-Bandleiter (10) mit mehreren Lagen einer Metallfaser umwickelt ist.

2. Supraleitender Fehlerstrombegrenzer oder Schalter nach Anspruch 1, wobei die Metallfaser eine Kupfer- oder Refraktärmetallfaser umfasst.

3. Supraleitender Fehlerstrombegrenzer oder Schalter nach Anspruch 1, ferner umfassend eine Messleitung (17), wobei die Messleitung am Rand des HTS-Bandleiters oder auf und entlang einer der Hauptflächen des HTS-Bandleiters angeordnet ist.

4. Supraleitender Fehlerstrombegrenzer oder Schalter nach Anspruch 3, wobei die Messleitung (17) einen Lichtwellenleiter, vorzugsweise eine Glasfaser, umfasst.

5. Supraleitender Fehlerstrombegrenzer oder Schalter nach Anspruch 1, wobei auf eine HTS-Seite einer HTS-Bandleiteroberfläche des HTS-Bandleiters (10) ein zweiter HTS-Bandleiter (10) mit zugewandter HTS-Seite als Patch (16) aufgelötet ist.

6. Verfahren zur Herstellung eines supraleitenden Fehlerstrombegrenzers oder Schalters , aufweisend:
Umwickeln (510) eines HTS-Bandleiters (10) mit zumindest einer Lage einer Faser (15), die einen im Wesentlichen runden Querschnitt aufweist, um den HTS-Bandleiter (10) mit einer Armierung zu versehen; und Umwickeln des HTS-Bandleiters (10) mit mehreren Lagen einer Metallfaser;
wobei vorzugsweise die Zugspannung beim Umwickeln im Bereich von 50 bis 250 MPa liegt; und wobei ein Vorschub des HTS-Bandleiters (10) und eine Umwickelfrequenz so aufeinander abgestimmt sind, dass die Faser (15) pro Wicklung um einen Faserdurchmesser versetzt wird.

## Claims

1. A superconducting fault current limiter or switch comprising:
a high temperature superconducting, HTS, tape conductor (10) having a width (W) and a thickness (D); and
an armoring formed by wrapping the HTS tape conductor (10) with a first layer of at least one fiber (15) of a first type having a substantially round cross section,
wherein the fiber (15) is wrapped substantially without overlap and abutting closely to each other, wherein
the HTS tape conductor (10) is wrapped with multiple layers of a metal fiber.

2. The superconducting fault current limiter or switch of claim 1, wherein the metal fiber comprises a copper or refractory metal fiber.

3. The superconducting fault current limiter or switch of claim 1, further comprising a sense line (17), wherein the sense line is located at the edge of the HTS tape conductor or on and along one of the major surfaces of the HTS tape conductor.

4. The superconducting fault current limiter or switch of claim 3, wherein the sense line (17) comprises an optical fiber, preferably a glass fiber.

5. The superconducting fault current limiter or switch of claim 1, wherein a second HTS tape conductor (10) with facing HTS side is soldered as a patch (16) to an HTS side of an HTS tape conductor surface of the HTS tape conductor (10).

6. A method of manufacturing a superconducting fault current limiter or switch comprising:
wrapping (510) an HTS tape conductor (10) with at least one layer of a fiber (15) having a substantially round cross section to provide the HTS tape conductor (10) with an armoring; and
wrapping the HTS tape conductor (10) with multiple layers of a metal fiber;
wherein preferably the tensile stress during wrapping is in the range of 50 to 250 MPa; and wherein a feed of the HTS tape conductor (10) and a wrapping frequency are tuned to each other such that the fiber (15) is offset by one fiber diameter per winding.

## Revendications

1. Limiteur de courant de défaut ou commutateur supraconducteur, comportant :
un conducteur en bande (10) supraconducteur à haute température, conducteur HTS en bande, qui présente une largeur (W) et une épaisseur (D) ; et
une armature, qui est réalisée telle que le conducteur HTS en bande (10) est enroulé avec une première couche d'au moins une fibre (15) d'un premier type, qui présente une section sensiblement ronde, dans lequel la fibre (15) est enroulée sensiblement sans chevauchement et de manière mutuellement serrée bout à bout, dans lequel le conducteur HTS en bande (10) est enroulé avec plusieurs couches d'une fibre métallique.

2. Limiteur de courant de défaut ou commutateur supraconducteur selon la revendication 1, dans lequel la fibre métallique comprend une fibre métallique de cuivre ou réfractaire.

3. Limiteur de courant de défaut ou commutateur supraconducteur selon la revendication 1, comprenant en outre une ligne de mesure (17), dans lequel la ligne de mesure est disposée sur le bord du conducteur HTS en bande ou sur, et le long de, l'une des surfaces principales du conducteur HTS en bande.

4. Limiteur de courant de défaut ou commutateur supraconducteur selon la revendication 3, dans lequel la ligne de mesure (17) comprend un conducteur d'ondes lumineuses, de préférence une fibre de verre.

5. Limiteur de courant de défaut ou commutateur supraconducteur selon la revendication 1, dans lequel un deuxième conducteur HTS en bande (10) est brasé comme patch (16) avec un côté HTS orienté sur un côté HTS d'une surface de conducteur HTS en bande du conducteur HTS en bande (10).

6. Procédé de fabrication d'un limiteur de courant de défaut ou d'un commutateur supraconducteur, comportant :
l'enroulement (510) d'un conducteur HTS en bande (10) avec au moins une couche d'une fibre (15) qui présente une section transversale sensiblement ronde, pour munir le conducteur HTS en bande (10) d'une armature ; et
l'enroulement du conducteur HTS en bande (10) avec plusieurs couches d'une fibre métallique ;
dans lequel la contrainte de traction lors de l'enroulement se situe de préférence dans la plage allant de 50 à 250 MPa ; et
dans lequel une avance du conducteur HTS en bande (10) et une fréquence d'enroulement sont adaptées l'une à l'autre de telle sorte que la fibre (15) soit décalée d'un diamètre de fibre par enroulement.
